(19) Europäisches Patentamt
European Patent Office
Office européen des brevets

(11) **EP 4 148 613 A1**

(12) **EUROPÄISCHE PATENTANMELDUNG**

(43) Veröffentlichungstag:
**15.03.2023 Patentblatt 2023/11**

(21) Anmeldenummer: **22194640.3**

(22) Anmeldetag: **08.09.2022**

(51) Internationale Patentklassifikation (IPC):
*G06F 30/34* (2020.01)   *G06F 30/18* (2020.01)
*G06F 30/33* (2020.01)   *G06F 30/343* (2020.01)
*G06F 30/347* (2020.01)   *G06F 30/327* (2020.01)

(52) Gemeinsame Patentklassifikation (CPC):
**G06F 30/18; G06F 30/327; G06F 30/33;
G06F 30/34; G06F 30/343; G06F 30/347**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **10.09.2021 DE 102021123496**

(71) Anmelder: **dSPACE GmbH**
**33102 Paderborn (DE)**

(72) Erfinder:
• **Lubeley, Dominik**
  **33102 Paderborn (DE)**
• **Kalte, Heiko**
  **33102 Paderborn (DE)**
• **Schlenger, Marc**
  **33102 Paderborn (DE)**

(54) **VERFAHREN ZUM HINZUFÜGEN EINER WEITEREN SCHALTUNGSKOMPONENTE**

(57) Gegenstand der Erfindung ist ein Verfahren zum Hinzufügen einer weiteren Schaltungskomponente (1) mit auf einem FPGA ausführbaren Operationen zu einer FPGA Konfiguration (3), wobei
die FPGA Konfiguration (3) bereits wenigstens eine in der FPGA Konfiguration (3) örtlich verteilt angeordnete bestehende Schaltungskomponente (2) mit auf dem FPGA ausführbaren Operationen aufweist, mit den Schritten:
Synthetisieren der weiteren Schaltungskomponente (1) zum Erhalten einer weiteren Netzliste, und
verteiltes Anordnen der weiteren Netzliste unter Berücksichtigung der wenigstens einen bestehenden Schaltungskomponente (2) in der FPGA Konfiguration (3).

Schaltungskomponente 5
Schaltungskomponente 4
Schaltungskomponente 3
Schaltungskomponente 2
Schaltungskomponente 1
2
„Merged Component Stack"
1
3

Fig. 2

EP 4 148 613 A1

**Beschreibung**

Technisches Gebiet

Die Erfindung betrifft ein Verfahren zum Hinzufügen einer weiteren Schaltungskomponente mit auf einem FPGA ausführbaren Operationen zu einer FPGA Konfiguration, wobei die FPGA Konfiguration bereits wenigstens eine, in der FPGA Konfiguration örtlich verteilt angeordnete, bestehende Schaltungskomponente mit auf dem FPGA ausführbaren Operationen aufweist. Die Erfindung betrifft ferner ein nichtflüchtiges, computerlesbares Speichermedium mit darauf abgespeicherten Befehlen, die bei ihrer Ausführung auf einem Prozessor das Verfahren bewirken.

Hintergrund der Erfindung

Ein FPGA ist ein integrierter Schaltkreis der Digitaltechnik, in den eine logische Schaltung geladen werden kann. Im Unterschied zur Programmierung von Computern, Mikrocontrollern und Steuerungen meint der Begriff "Programmierung" bzw. "Bauen des FPGA" bei FPGAs nicht nur die Vorgabe zeitlicher Abläufe, sondern auch die Definition der angestrebten Schaltungsstruktur. Diese Schaltungsstruktur wird mittels einer Hardware-Beschreibungssprache formuliert und dann softwaremäßig in eine Konfigurationsdatei übersetzt, die vorgibt, wie die Elemente im FPGA verschaltet werden sollen. Bei der FPGA-Programmierung erzeugt man also eine Beschreibung der Hardware-Struktur, die dann mit Hilfe von Synthese- und Routing-Werkzeugen auf den eigentlichen FPGA übertragen wird. Diese Hardware-Beschreibung findet typischerweise in speziellen Sprachen, wie VHDL oder Verilog statt. Anstelle von "FPGA-Programm" spricht man dabei deshalb auch von einer "FPGAKonfiguration". Im Gegensatz zur Programmierung von Computern, Mikroprozessoren und Steuerungen richtet sich die FPGA-Programmierung somit nicht an einem vorgegebenen Betriebssystem und einer Treiberbasis aus. Stattdessen zielt die FPGA-Programmierung auf die Definition von Strukturen im Halbleiter ab, die später die beabsichtigten Funktionen ausführen. Auf diese Weise ist ein Spezialisierungs- und Parallelitätsgrad erzielbar, der von herkömmlichen, vorgefertigten Mikroprozessoren nur schwer zu erreichen ist.

Im Bereich der Hardware in the Loop-Simulation (HIL-Simulation) und bei Rapid Control Prototyping-Systemen (RCP-Systemen) können Echtzeitsimulationen, zum Beispiel in den technischen Bereichen Leistungselektronik und Elektromobilität, schon längere Zeit nicht mehr durch reine Prozessormodelle abgedeckt werden. Bei vielen Anwendungsfällen, wie Simulationen, in denen sehr schnelle Regelkreise erforderlich sind, müssen diese durch FPGA-Modelle ergänzt oder gar ersetzt werden. Derartige Hardware für HIL-Simulationen und bei Rapid Control Prototyping-Systeme verfügen über eine Vielzahl von FPGAs mit getesteten Firmwareständen für unterschiedliche Funktionalitäten bzw. Schaltungskomponenten, beispielsweise FPGAs für eine Kommunikation in einem Echtzeitnetzwerk und FPGAs, welche unterschiedliche I/O Funktionalitäten auf I/O Kanälen realisieren können.

Sobald eine Änderung an der Funktionalität erforderlich wird, muss die Funktionalität neu implementiert, der FPGA neu gebaut und jede einzelne Funktionalität, also sowohl vorhandene Funktionalitäten als auch die neue Funktionalität, getestet und freigegeben werden. Dies ist dadurch bedingt, da beim Bauen des FPGA-Firmwarestands die Funktionalität jeder einzelnen Schaltungskomponente über Grenzen der Schaltungskomponente hinweg optimiert, auf dem FPGA platziert und neu geroutet werden muss. Selbst eine Änderung eines einzelnen Bits oder Signals kann zu einem unterschiedlichen Ergebnis führen. Insofern kann jede einzelne Funktionalität ein abweichendes Timingverhalten haben, abhängig von der Platzierung auf dem FPGA. Die dadurch erforderlichen Tests erzeugen selbst bei nur minimalen Änderungen einen hohen Aufwand, die sich von der Hardwareentwicklung über die Softwareentwicklung bis zum Systemtest ziehen kann, da immer die Gesamtfunktionalität des FPGA getestet werden muss. Insbesondere in der Hardwareentwicklung ist dies problematisch, da der Firmwarestand aufwendig in einem Klimaschrank getestet werden muss, um zu garantieren, dass der Firmwarestand unter allen für das Produkt spezifizierten Umweltbedingungen funktioniert.

Beschreibung der Erfindung

Ausgehend von dieser Situation ist es eine Aufgabe der vorliegenden Erfindung, eine Verfahren zum Ändern einer Funktionalität einer FPGA Konfiguration anzugeben, welches gegenüber den aus dem Stand der Technik bekannten Verfahren durch einen geringen Testaufwand gekennzeichnet ist.

Die Aufgabe der Erfindung wird durch die Merkmale der unabhängigen Ansprüche gelöst. Vorteilhafte Ausgestaltungen sind in den Unteransprüchen angegeben.

Demnach wird die Aufgabe gelöst durch ein Verfahren zum Hinzufügen einer weiteren Schaltungskomponente mit auf einem FPGA ausführbaren Operationen zu einer FPGA Konfiguration, wobei die FPGA Konfiguration bereits wenigstens eine in der FPGA Konfiguration örtlich verteilt angeordnete bestehende Schaltungskomponente mit auf dem FPGA ausführbaren Operationen aufweist, mit den Schritten:

Synthetisieren der weiteren Schaltungskomponente zum Erhalten einer weiteren Netzliste, und

verteiltes Anordnen der weiteren Netzliste unter Berücksichtigung der wenigstens einen bestehenden Schaltungskomponente in der FPGA Konfiguration.

Ein wesentlicher Punkt des vorgeschlagenen Verfahrens liegt darin, dass im Gegensatz zum Stand der Technik nur noch Änderungen an der FPGA Konfiguration getestet werden müssen, nicht jedoch eine Gesamtfunktionalität der FPGA Konfiguration, wodurch ein Zeit- und Kostenaufwand stark reduziert wird. Bei derartigen Anwendungsfällen wurde im Stand der Technik ein festes sogenanntes Floorplaning vorausgesetzt, bei dem Schaltungskomponenten in festen Regionen, sogenannten Pblocks, in der FPGA Konfiguration platziert wurden. Im Gegensatz dazu ermöglicht das vorgeschlagene Verfahren eine Verwendung von insbesondere abgesicherten Schaltungskomponenten in veränderlicher Logik ohne Floorplaning. Das Verfahren nutzt für weitere Schaltungskomponenten, die beispielsweise durch Kunden und nicht durch einen Hersteller erstellt werden, vorhandene Freiräume aus. Dabei wird ein Gesamt-Timing des FPGA nicht durch starre Pblock Grenzen beeinflusst und/oder Schaltungskomponenten sind nicht vorab auf eine feste Pblock Größe festgelegt. Das bedeutet, dass das verteilte Anordnen der weiteren Netzliste unter Berücksichtigung der wenigstens einen bestehenden Schaltungskomponente nicht auf eine feste Region in der FPGA Konfiguration beschränkt ist, wie im Stand der Technik praktiziert. Mit anderen Worten wird im Gegensatz zu einer reinen "Incremental Implementation" ein sogenanntes Komponentenhandling realisiert.

Zusammengefasst ermöglicht das vorgeschlagene Verfahren einen sicheren Betrieb von abgesicherten Schaltungskomponenten in veränderlicher FPGA Logik, wobei das Timing gesichert ist und Standardszenarien für Leistungsaufnahme getestet sind, und kürzere Buildzeiten durch Vorplatzierung möglich sind. Durch das Verfahren entfällt die Notwendigkeit eines Floorplanings, während mehr Freiheitsgrade für Platzierungs- und Routing-Werkzeuge des FPGA Herstellers erzeugt werden. Ferner findet keine Verschwendung von ungenutzten Ressourcen durch Verschnitt statt, da grundsätzlich alle Freiräume, die noch übrig sind, genutzt werden können. Zudem ist durch das Verfahren kein ideales Vorplatzieren der Schaltungskomponenten notwendig und auch das Gesamt-Timing wird nicht durch starre Pblock Grenzen beeinträchtigt. Ferner werden auch keine zusätzlichen Übergaberegister an den Pblock Grenzen benötigt, um Timingprobleme zu vermeiden. Schließlich findet kein Verwerfen vieler und/oder aller Schaltungskomponenten statt, wenn eine Schaltungskomponenten zu groß für ihren Pblock wird. Zudem entsteht eine tendenziell gleichmäßigere Verteilung der Temperaturentwicklung, da keine lokalen Hotspots, durch extrem aktive Pblock, entstehen. Ebenso ermöglicht das Verfahren, dass die Schaltungskomponenten automatisch nahe an ihre I/O platziert werden. Für einen Klimaschranktest kann die Komponentenfunktionalität um eine zusätzliche Heat-Applikation, beispielsweise schaltende FlipFlops, Oszillatoren ohne Register, etc. , erweitert werden, welche den FPGA aufheizen kann, so dass sich Worst Case Szenarien absichern lassen.

Nach einer bevorzugten Weiterbildung umfasst das Anordnen den Schritt:
Inkrementelles Hinzufügen der weiteren Netzliste bei gesperrter wenigstens einer bestehenden Schaltungskomponente.

Gemäß einer anderen bevorzugten Weiterbildung umfasst das Verfahren den Schritt nach dem Anordnen:
Entfernen der wenigstens einen bestehenden Schaltungskomponente.

Nach einer bevorzugten Weiterbildung umfasst das Entfernen die Schritte:

Sperren der weiteren Schaltungskomponente, und
sequentielles Entfernen wenigstens einer bestehenden Netzliste der wenigstens einen bestehenden Schaltungskomponente.

Mittels dieser Schritte kann eine fertig platzierte und geroutete FPGA Konfiguration als Referenzdesign verwendet werden, wobei insbesondere alle Schaltungskomponenten, die auch im aktuellen Design vorkommen, identisch erhalten bleiben, jedoch ungenutzte Schaltungskomponenten automatisch entfernt werden können. Ebenso kann mit Hilfe der FPGA Konfiguration eine Bibliothek von fertig platzierten gerouteten Einzel-Schaltungskomponenten erstellt werden und für alle im aktuellen Design verwendeten Schaltungskomponenten werden für den Build das fertige Placement & Routing der Einzel-Schaltungskomponenten aus der Bibliothek übernommen.

Gemäß einer anderen bevorzugten Weiterbildung umfasst das Verfahren die Schritte:

Sperren der weiteren Schaltungskomponente, und
Exportieren der Anordnung der weiteren Schaltungskomponente zur Berücksichtigung beim Hinzufügen einer noch weiteren Schaltungskomponente.

Bei dieser Variante kann mit Hilfe der FPGA Konfiguration eine sogenannte Constraints Bibliothek erstellt werden, die neben der Beschreibung der Funktionalität in einer synthetisierten Netzliste oder einer Sprache wie beispielsweise VHDL oder Verilog oder einer graphischen Modellierung der Schaltungskomponente, nur deren Constraints enthält. Die Netzlisten aller Schaltungskomponenten werden nicht fertig plaziert und geroutet abgespeichert sondern nur die unplatzierten und ungerouteten Netzlisten und deren Constraints, die ein identisches Place & Route erzwingen.

Nach einer bevorzugten Weiterbildung umfasst das Verfahren den Schritt:

Einlesen der wenigstens einen bestehenden Schaltungskomponente einschließlich der wenigstens einen bestehenden Netzliste, und/oder

Entfernen nicht verwendeter Schaltungskomponenten aus der Anordnung der weiteren Schaltungskomponente zusammen mit der wenigstens einen bestehenden Schaltungskomponente.

Gemäß einer anderen bevorzugten Weiterbildung erfolgt das Anordnen der weiteren Schaltungskomponente unter Beibehaltung einer Anordnung der wenigstens einen bestehenden Schaltungskomponente. Nach einer bevorzugten Weiterbildung erfolgt das Anordnen in durch die wenigstens eine bestehende Schaltungskomponente unbelegten Freiräumen der FPGA Konfiguration. Die FPGA Konfiguration kann eine Mehrzahl bestehender Schaltungskomponenten umfassen.

Verteiltes Anordnen der weiteren Netzliste unter Berücksichtigung der wenigstens einen bestehenden Schaltungskomponente in der FPGA Konfiguration, insbesondere örtlich verteiltes Anordnen, bedeutet insbesondere, dass die Anordnung jeder Schaltungskomponente nicht in einem dedizierten Freiraum erfolgt, also jede Schaltungskomponente derart separat und/oder beabstandet voneinander angeordnet ist, sondern sich die Schaltungskomponenten geografisch betrachtet überlappen können. Nach einer bevorzugten Weiterbildung sind durch das Anordnen die wenigstens eine bestehende Schaltungskomponente und die weitere Schaltungskomponente in gleichen Partitionen der FPGA Konfiguration platziert und/oder sind die wenigstens eine bestehende Schaltungskomponente und die weitere Schaltungskomponente partitionsfrei in der FPGA Konfiguration angeordnet.

Nach einer bevorzugten Weiterbildung weist das Verfahren den Schritt auf:

Einzelnes Testen der wenigstens einen bestehenden Schaltungskomponente und der weiteren Schaltungskomponente.

Das Testen erfolgt bevorzugt in einem Klimaschrank und/oder mittels einer Lastgenerierungslogik, beispielsweise massives FlipFlop-Umschalten.

Gemäß einer anderen bevorzugten Weiterbildung sind eine Mehrzahl bestehender unter jeweiliger Berücksichtigung anderer bestehender Schaltungskomponenten verteilt angeordneter Schaltungskomponenten auf der FPGA Konfiguration vorgesehen und/oder umfasst das Verfahren den Schritt:

Anordnen einer Mehrzahl weiterer Schaltungskomponenten.

Bevorzugt werden die Mehrzahl weiterer Schaltungskomponenten wie zuvor beschrieben mittels Synthetisieren der jeweiligen weiteren und verteiltes Anordnen der jeweils weiteren Netzliste angeordnet. Bevorzugt weisen die einzelnen Schaltungskomponenten jeweils unterschiedliche auf dem FPGA ausführbare Operationen auf.

Nach einer bevorzugten Weiterbildung sind eine Mehrzahl bestehender unter jeweiliger Berücksichtigung anderer bestehender Schaltungskomponenten verteilt angeordneter Schaltungskomponenten auf der FPGA Konfiguration vorgesehen und umfasst das Verfahren den Schritt:

sequentielles Entfernen mindestens einer bestehenden Schaltungskomponente aus der FPGA Konfiguration und Ersetzen der entfernten Schaltungskomponente durch eine andere Version der Schaltungskomponente, die unter Berücksichtigung aller anderen bestehenden Schaltungskomponenten erstellt wurde.

Nach einer bevorzugten Weiterbildung weist die FPGA Konfiguration wenigstens eine verteilt angeordnete weitere Schaltungskomponente auf, die sequentiell entfernt wird und deren andere Version in Freiräume insbesondere der entfernten Schaltungskomponente oder über alle vorhandenen Freiräume angeordnet wird.

Derart lässt sich beispielsweise ein Update einer Schaltungskomponente wie beispielsweise "Netzwerk" in einer FPGA Konfiguration bewirken, die nur aus konfliktfrei angeordneten Schaltungskomponenten besteht. Dies ist auch bei beliebig platzierten Schaltungskomponenten möglich, die vor dem Update gelöscht und nach dem Update in neu entstehende Freiräume platziert werden.

Die Aufgabe wird weiterhin gelöst durch ein nichtflüchtiges, computerlesbares Speichermedium mit darauf abgespeicherten Befehlen, die bei ihrer Ausführung auf einem Prozessor ein zuvor beschriebenes Verfahren bewirken.

Kurze Beschreibung der Zeichnungen

Nachfolgend wird die Erfindung unter Bezugnahme auf die anliegenden Zeichnungen anhand bevorzugter Ausführungsbeispiele näher erläutert.

In den Zeichnungen zeigen

Fig. 1    eine exemplarische Stand der Technik-Anwendung,

Fig. 2    eine Anwendung gemäß dem vorgeschlagenen Verfahren in einer schematischen Ansicht,

Fig. 3    eine weitere Ausgestaltung der Anwendung des vorgeschlagenen Verfahrens in einer schematischen Ansicht, und

Fig. 4    eine noch weitere Ausgestaltung der Anwendung des vorgeschlagenen Verfahrens in einer schematischen Ansicht, und

Detaillierte Beschreibung der Ausführungsbespiele

Moderne FPGA Tools bieten verschiedene Optionen zur Synthese, Generierung von Netzlisten, und zur Implementierung, Place & Route, von FPGAs an. Während der Synthese können die Netzlisten für die Schaltungskomponenten beispielsweise in ihrer Hierarchie erhalten bleiben oder über Schaltungskomponentengrenzen hinweg dehierarchisiert und somit besser optimiert werden.

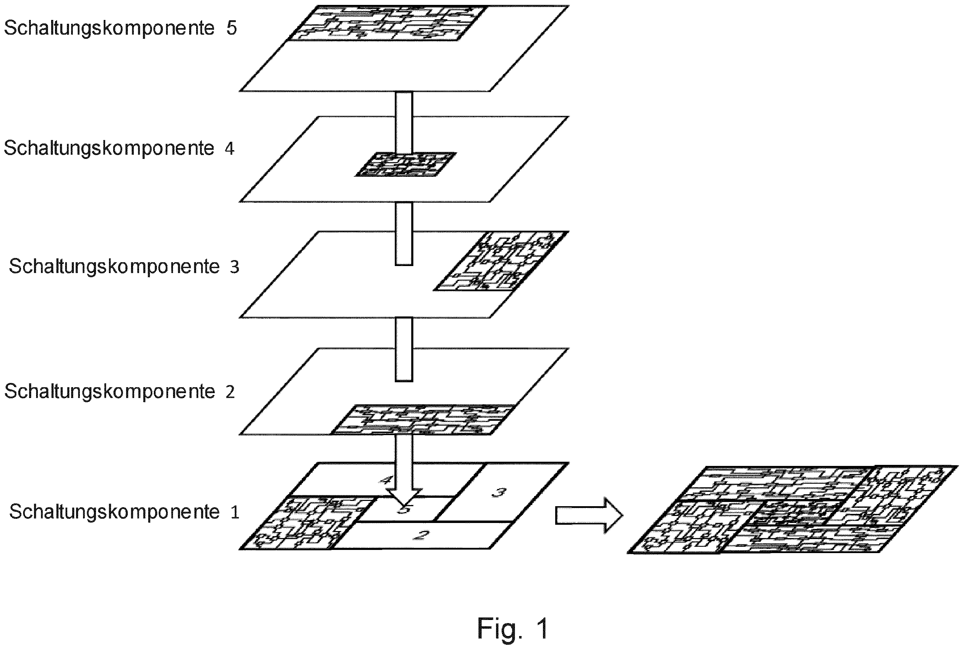

Fig. 1 zeigt eine exemplarische Stand der Technik-Anwendung, bei der ein Kunde mit jedem Build seiner Kunden-FPGA Konfiguration gegebenenfalls auch verwendete bestehende Schaltungskomponenten gegebenenfalls aus Bibliotheken mitbauen musste. Jeder Build resultierte in einer neuen optimierten Netzliste, in einem neuen Placement und in einem neuen Routing für bestehenden Schaltungskomponenten, die neben der Kundenfunktionalität im FPGA Bitstrom enthalten sind. Bibliotheken liegen in diesem Fall noch in einer Hardwarebeschreibungssprache wie beispielsweise VHDL, Verilog oder in Form einer graphischen Modellierung, aus der mit einem Codegenerator beispielsweise VHDL oder Verilog generiert wird, ggf. mit einem Zwischenschritt über eine andere Sprache wie beispielsweise C, wenn Tools für eine High Level Synthese (HLS) verwendet werden.

Alternativ kann die Fläche des FPGAs durch Floorplaning in verschiedene Regionen, Pblock genannt, für einzelne Schaltungskomponenten aufgeteilt werden, wie in Fig. 1 gezeigt, die einzeln platziert und geroutet werden können. Die Unterteilung in starren Pblocks dient gleichzeitig als Grundlage für eine dynamische partielle Rekonfiguration, bei der einzelne Schaltungskomponenten zur Laufzeit des FPGAs ausgetauscht werden können. Eine Aufteilung der Schaltungskomponenten auf verschiedene Regionen, ist das Verfahren des Stands der Technik, um bestehende Schaltungskomponenten, mit den gravierenden Einschränkungen des Floorplanings und der Pblocks, auch fest platziert und geroutet verwenden zu können. Bibliotheken können also wie oben beschrieben vorliegen und werden dann auf einen Pblock platziert, so dass Schaltungskomponenten als fertig für ihren Pblock platzierte Netzlisten in der Bibliothek vorliegen.

Das im folgenden beschriebene Verfahren eines flexiblen "Component Stack" ermöglicht Testaufwände zu reduzieren und zukünftige in Kunden-FPGA Applikationen eingebaute Schaltungskomponenten durch neuere, gesicherte Versionen tauschen zu können.

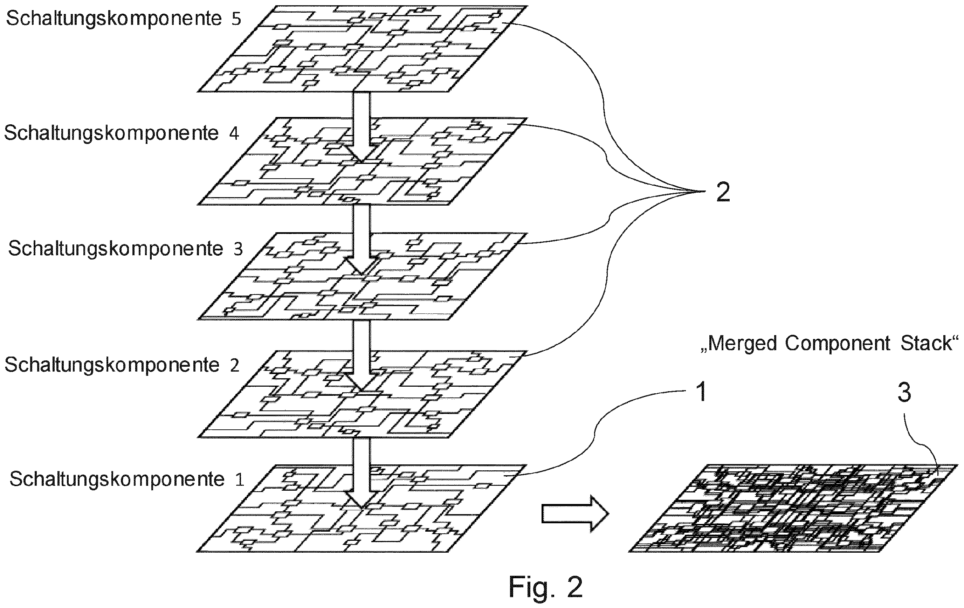

Im Gegensatz zum zuvor beschriebenen Ansatz mit Floorplaning müssen bei dem nachfolgend beschriebenen Verfahren keine Regionen des FPGA für die einzelnen Schaltungskomponenten festgelegt werden. Jede Schaltungskomponente kann beliebig im FPGA platziert sein. Allerdings darf die Schaltungskomponente keine Ressourcen verwenden, die bereits von einer anderen Schaltungskomponente belegt sind und sie muss als dediziertes Stack-Element auswählbar sein. Zur Sicherstellung dessen bieten sich die im Folgenden vorgestellten drei Vorgehensweisen an, die anhand der Fig. 2 erläutert werden.

Fig. 2 zeigt eine weitere Schaltungskomponente 1 mit auf einem FPGA ausführbaren Operationen links unten, die zu vier bestehenden links oben gezeigten Schaltungskomponenten 2 in eine FPGA Konfiguration 3 eingefügt werden soll. Die vier bestehenden Schaltungskomponenten 2 sind örtlich verteilt in der FPGA Konfiguration 3 angeordnet, also jeweils nicht auf eine Region des FPGA beschränkt. Zum Hinzufügen werden zwei grundsätzliche Schritte durchlaufen, so zunächst (a) Synthetisieren der weiteren Schaltungskomponente 1 zum Erhalten einer weiteren Netzliste der weiteren Schaltungskomponente 1, und (b) verteiltes Anordnen der weiteren Netzliste unter Berücksichtigung der wenigstens einen bestehenden Schaltungskomponente 2 in der FPGA Konfiguration 3.

Das Anordnen der weiteren Schaltungskomponente 1 erfolgt unter Beibehaltung einer Anordnung der wenigstens einen bestehenden Schaltungskomponente 2 in unbelegten Freiräumen der FPGA Konfiguration 3. Durch das Anordnen werden die wenigstens eine bestehende Schaltungskomponente 2 und die weitere Schaltungskomponente 1 in gleichen Partitionen der FPGA Konfiguration 3 platziert, so dass die wenigstens eine bestehende Schaltungskomponente 2 und die weitere Schaltungskomponente 1 partitionsfrei in der FPGA Konfiguration 3 angeordnet sind.

Zum Ausgestalten dieses Verfahrens existieren verschiedene Möglichkeiten.

Bei der sogenannten subtraktiven Methode wird ein fertig platzierter und gerouteter "Merged Component Stack" als Referenzdesign verwendet, in Fig. 2 rechts schematisch als FPGA Konfiguration 3 gezeigt. Alle Schaltungskomponenten des "Merged Component Stacks", die auch in einem aktuellen Design vorkommen, bleiben identisch erhalten, ungenutzte Schaltungskomponenten werden automatisch entfernt. Diese Methode kann Merkmales des sogenannten Incremental Compilation nutzen.

Bei der sogenannten additiven Methode wird mit Hilfe des "Merged Component Stacks" eine Bibliothek von fertig platzierten gerouteten einzelnen Schaltungskomponenten erstellt. Für alle im aktuellen Design verwendeten Schaltungskomponenten wird für den Build das fertige Placement & Routing der einzelnen Schaltungskomponenten aus der Bibliothek übernommen. Diese Methode kann Merkmale des sogenannten Hierarchical Design Flows nutzen. Aus dem Hierarchischem Design Flow ist das Locken von bereits platzierten und gerouteten Schaltungskomponenten mit Pblocks bekannt. Außerdem ist es erforderlich, neben dem Locken des Placements der Cells, LOC Constraints, der von den Cells verwendeten Basic Elements, BEL Constraints, und des Routings inklusive Setting der programmable Interconnects (PIPs), ROUTE_FIXED Constraints, zusätzlich die Pins der Basic Elements zu locken, LOCK PINS Constraints.

Die sogenannte Constraints Methode ist die einfachste Methode, da nicht die Schaltungskomponenten fertig platziert und geroutet verwendet werden, sondern nur deren Constraints, um ein identisches Place & Route zu erzwingen. Diese Methode kann mit Hilfe des "Merged Component Stacks" eine Constraints Bibliothek erstellen, die neben der Beschreibung der Funktionalität in einer synthetisierten Netzliste oder einer Sprache wie z.B. VHDL oder Verilog oder einer graphischen Modellierung der Schaltungskomponente, nur deren Constraints enthält.

Das Erstellen einer Bibliothek von Schaltungskomponenten beinhaltet folgende Schritte: Bei der subtraktiven und additiven Methode erfolgt zunächst ein inkrementelles Hinzufügen der weiteren Netzliste bei gesperrter wenigstens einer bestehenden Schaltungskomponente 2. Bei der subtraktiven Methode wird sodann die wenigstens eine bestehende Schaltungskomponente 2 entfernt, wobei die weitere Schaltungskomponente 1 gesperrt wird. Bei der Constraints Methode erfolgt zunächst das Sperren der weiteren Schaltungskomponente 1, und sodann das Exportieren der Anordnung der weiteren Schaltungskomponente 1 zur Berücksichtigung beim Hinzufügen einer noch weiteren Schaltungskomponente 1. Zuvor erfolgt ein Einlesen der wenigstens einen bestehenden Schaltungskomponente 2 einschließlich der wenigstens einen bestehenden Netzliste. Nicht verwendete Schaltungskomponenten können aus der Anordnung der weiteren Schaltungskomponente 1 zusammen mit der wenigstens einen bestehenden Schaltungskomponente 2 entfernt werden.

Zum Erstellen einer weiteren FPGA Schaltungskomponente 1 wird bei der subtraktiven Method zunächst die weitere Schaltungskomponente 1 synthetisiert, wobei die weitere Schaltungskomponente 1 als dediziertes Objekt Out of Context, OOC, synthetisiert wird. Die Synthese erfolgt in einem festgelegten Wrapper, damit ein Netzlistenpfad der weiteren Schaltungskomponente 1 immer identisch ist. Sodann wird die weitere Netzliste der weiteren weitere Schaltungskomponente 1 exportiert, um diese als Netzlistenbibliothek zu erhalten. Zum Implementieren (Place & Route) der weiteren Schaltungskomponente 1 wird diese zusammen mit einem Wrapper und allen schon bestehenden Schaltungskomponenten 2 platziert und gerouted. Dabei wird das Placement und Routing aller schon bestehenden Schaltungskomponenten 2 gelockt und nur die neue Netzliste inkrementell hinzugefügt.

Die im Folgenden mehrfach exemplarisch verwendete Syntax entspricht dem FPGA Tool Xilinx Vivado, ist somit in ihrer Explizität produkt- und versionsgebunden, in ihrer Implizität aber hinreichend selbstsprechend.

*read_checkpoint -incremental <design_of_merged_component_stack> -fix_reuse*

*place_design*

*route_design*

Als Ergebnis erhält man eine neue FPGA Konfiguration 3, in dem alle bestehenden Schaltungskomponenten 2 einschließlich der weiteren Schaltungskomponente 1 enthalten sind.

Bei der Additiven Methode wird die weitere Schaltungskomponente 1 zunächst analog zur subtraktiven Methode synthetisiert und dann ebenso analog zur subtraktiven Methode implementiert. Sodann werden alle anderen Schaltungskomponenten 2 aus dem platzierten und gerouteten Design entfernt durch:

1. Locken des Placements und Routings der weiteren Schaltungskomponente 1.

*lock_component <netlist_path_of_component_in_wrapper>*

2. Sequentielles Entfernen der Netzlisten aller alten Schaltungskomponenten 2.

*remove_net <netlist_paths_of_all_other_component_in_wrapper>*

*remove_cell <netlist_paths_of_all_other_component_in_wrapper>*

3. Platzieren des Gesamtdesigns, wobei das Placements der weiteren Schaltungskomponente 1 beibehalten und alle anderen nicht verwendeten Schaltungskomponenten entfernt werden, da sie keine Entsprechung in der Netzliste des zu platzierenden Designs haben.

*place_design -unplace*

*place_design*

4. Routen des Gesamtdesigns, wobei das Routing der weiteren Schaltungskomponente 1 beibehalten und alle anderen nicht verwendete Routen der Schaltungskomponenten entfernt werden, da sie keine Entsprechung in der Netzliste des zu routenden Designs haben.

*route_design -unroute*

*route_design*

5. Abspeichern des Checkpoints der weiteren Schaltungskomponente 1.

Bei der der Constraints Methode findet die Synthese analog zur additiven und/oder subtraktiven Methode jedoch ohne Netzlistenexport statt. Aus einem fertig platzierten Design, das auch aus mehreren Schaltungskomponenten bestehen kann, beispielsweise einem "Merged Component Stack", werden nicht die kompletten Schaltungskomponenten exportiert, sondern nur deren Constraints durch:

1. Locken des Placements und Routings der weiteren Schaltungskomponente 1.

*lock_component <netlist_path_of_component_in_wrapper>*

2. Export des Placement & Routing der weiteren Schaltungskomponente 1.

*write_xdc –type physical –cell <netlist_path_of_component_in_wrapper> component_physical.xdc*

Um mit diesem "(Merged) Component Stack", siehe Fig. 2 rechts, auch vereinfacht FPGA Konfiguration 3 genannt, so zu arbeiten, dass die vorhandenen Schaltungskomponenten 2 als fertig platzierte & geroutete Bibliothekselemente genutzt werden können, von denen nicht immer alle in einem FPGA verwendet werden müssen, gibt es in analoger Weise drei mögliche Vorgehensweisen:
Bei der subtraktiven Methode findet zunächst eine Synthese einschließlich Erstellen eines VHDL Codes beispielsweise eines Kundendesign oder einer Firmware statt, bei der Schaltungskomponenten aus der "Merged Component Stack" Bibliothek als Black Boxen verwendet werden können. Das Erstellen kann unter Zuhilfenahme eines Tools zur Generierung von VHDL Code aus einer graphischen Modellierungsumgebung oder einer Hochsprache wie beispielsweise C erfolgen. Im VHDL Code werden nur Entities d.h. Schnittstellendefinitionen der verwendeten Schaltungskomponenten eingebunden, was in einem festgelegten Wrapper erfolgt, damit ein Netzlistenpfad der Schaltungskomponente des Components Stacks identisch ist. Im Ergebnis bleiben die einzelnen Schaltungskomponenten in der Gesamtnetzliste erhalten, werden aber als Black Boxen behandelt.
Beim Ausführen der Synthese werden die Netzlisten der verwendeten Schaltungskomponenten aus der Netzlistenbibliothek des "Merged Component Stacks" hinzugefügt, damit bei einer späteren inkrementellen Implementierung die Netzliste des "Component Stack" Elements des neuen Designs als identisch zur Netzliste in der "Merged Component Stack" Referenz erkannt wird. Konkret wird für jede Schaltungskomponente einzeln ausgeführt:

*read_checkpoint <synthesized_component_checkpoint_filename>*

Im Rahmen der Implementierung, Place & Route, werden die gesamten implementierten "Merged Component Stacks" als Referenz eingelesen. Ebenso wird die Netzliste des "Merged Components Stacks" geladen, um verwendete Schaltungskomponenten des "Merged Component Stacks" in den Netzlisten des Kundendesign und/oder der Firmware wiederzufinden. Für die verwendeten Schaltungskomponenten wird das vorhandene Placement & Routing des Referenzdesigns ("Merged Component Stack") verwendet:

*read_checkpoint -incremental <design_of_merged_component_stack> -fix_reuse*

Das Gesamtdesigns wird unter Beibehaltung des gelockten Placements der Schaltungskomponenten des "Merged Component Stacks" plaziert. Nicht verwendete Schaltungskomponenten des "Merged Component Stacks" werden entfernt, da sie keine Entsprechung in der Netzliste des zu platzierenden Designs haben:

*place_design*

Das Routing des Gesamtdesigns erfolgt unter Beibehaltung des Routings der Schaltungskomponenten des "Merged Component Stacks". Das Routing zu nicht Schaltungskomponenten des "Merged Component Stacks" wird entfernt, da es keine Entsprechung in der Netzliste des zu routenden Designs hat.

*route design*

Bei der additiven Methode erfolgt zunächst ebenso die Synthese, analog zur subtraktiven Methode, und sodann die Implementierung, Place & Route. Zunächst werden die einzelnen benötigten Schaltungskomponenten des "Component Stacks" eingelesen. Für die verwendeten Schaltungskomponenten wird das vorhandene Placement & Routing wiederverwendet. Für jede Schaltungskomponente wird einzeln ausgeführt:

*read_checkpoint –cell <netlist_path_of_component_in_wrapper> <implemented_component_checkpoint_filename> -strict*

Sodann werden das Placement und Routing der verwendeten eingelesenen Schaltungskomponenten gelockt. Für jede Schaltungskomponente wird einzeln ausgeführt:

*lock_component <netlist_path_of_component_in_wrapper>*

Das Gesamtdesigns wird unter Beibehaltung des Placements der einzelnen Schaltungskomponenten des "Component Stacks" plaziert:

*place_design*

Schließlich erfolgt das Routing des Gesamtdesigns unter Beibehaltung des Routings der einzelnen Schaltungskomponenten des "Component Stacks":

*route_design*

Bei der Constraints Methode wird zunächst ebenso die Synthese analog zur additiven und subtraktiven Methode durchgeführt. Bei der Implementierung, Place & Route, werden zunächst die Constraints der einzelnen benötigten Schaltungskomponenten des "Component Stacks" eingelesen. Für die verwendeten Schaltungskomponenten wird das vorhandene Placement & Routing wiederverwendet. Für jede Schaltungskomponente wird einzeln ausgeführt:

*read_xdc component_physical.xdc*

Sodan wird das gesamte Design plaziert, wobei das Placement der einzelnen Schaltungskomponenten des "Component Stacks" durch die Constraints erzwungen wird.

*place_design*

Schließlich wird das gesamte Design geroutet, wobei das Routing der einzelnen Schaltungskomponenten des "Component Stacks" durch die Constraints erzwungen wird.

*route_design*

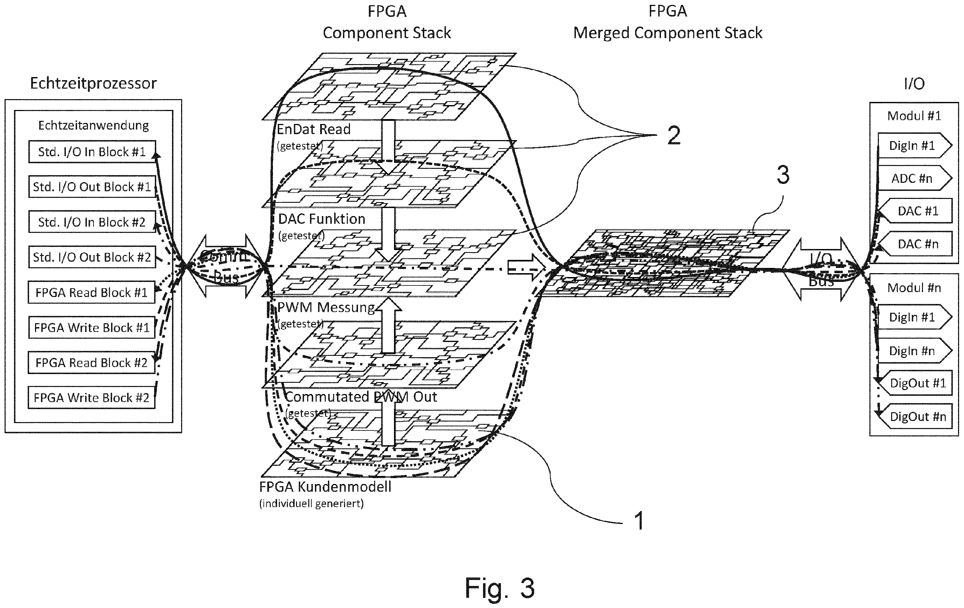

Durch Verwendung eines solchen "Component Stacks" als FPGA Konfiguration 3 ist ein Betrieb von abgesicherten (Firmware-)Schaltungskomponenten 1, 2 in veränderlicher FPGA Logik möglich. Neue Funktionen mit auf dem FPGA ausführbaren Operationen müssen nur einmalig und nicht jedes Mal getestet werden, wenn eine weitere Schaltungskomponente 1 hinzukommt oder eine bestehende Schaltungskomponente 2 verändert wird. Mit der vorgeschlagenen Lösung ist auf Basis des "Component Stacks" ein abgesicherter Betrieb von bestehenden Schaltungskomponenten, so beispielsweise auch "Standard I/O" Kanalfunktionalitäten zusammen mit beispielsweise veränderlicher Kunden FPGA Logik in einem FPGA möglich, wie in Fig. 3 dargestellt. Diese wahlweise exklusive Verwendung von FPGA I/O Kanälen für z.B. bestehende Standard I/O Schaltungskomponenten/Funktionalität wie z.B. eine PWM oder eine Resolverfunktionalität, die somit über ein Echtzeitnetzwerk einer Prozessor des Simulation bereitgestellt werden können, oder eben der Kunden FPGA Logik, trägt in Produkten der Firma dSPACE den Namen "Flexible I/O". Werden I/O Kanäle von Kunden FPGA Logik benutzt, stehen sie nicht für Standard I/O Komponenten zur Verfügung, diese Schaltungskomponenten müssen folglich auch nicht in der FPGA Konfiguration enthalten sein. Für Flexible I/O wird jede Standard I/O Kanalfunktionalität als eine Schaltungskomponente des "Component Stacks" realisiert. Es kann sowohl die additive, die subtraktive, als auch die Constraints Methode verwendet werden.

Beispielsweise kann ein Kunde, der sein FPGA Modell graphisch modelliert, bei jedem FPGA Build das gesamte Flexible I/O Framework mit aufbauen. Das Framework sorgt beispielsweise für eines Anbindung des FPGA Kundenmodells an den Kommunikationsbus und I/O und beinhaltet auch den Wrapper zwischen Kundenmodell und Framework Schaltungskomponenten. Spricht der Kunde die I/O Kanäle nicht direkt aus dem FPGA Modell an, können diese Kanäle von im FPGA implementierten Standard I/O Funktionen verwendet werden, wie in Fig. 3 angedeutet. Die Standard I/O Funktionen werden vom CPU Modell auf dem Echtzeitprozessor, also nicht vom FPGA Modell verwendet.

Für den FPGA Build werden neben dem FPGA Modell die Netzlisten des Flexible I/O Frameworks verwendet. In dem Framework sind die Standard I/O Kanalfunktionalitäten für die "Component Stack" basierte Synthese als Black Boxen definiert. Der Rest des Framework kann in der Synthese weiterhin dehierarchisiert und optimiert werden. Die Implementierung läuft analog wie zuvor beschrieben. Bei der additiven bzw. der Constraints Methode wird jeweils ein Constraint für das Locken des Placements & Routings für die im Kunden FPGA Modell genutzten Standard I/O Funktionalitäten und/oder Schaltungskomponenten angewendet.

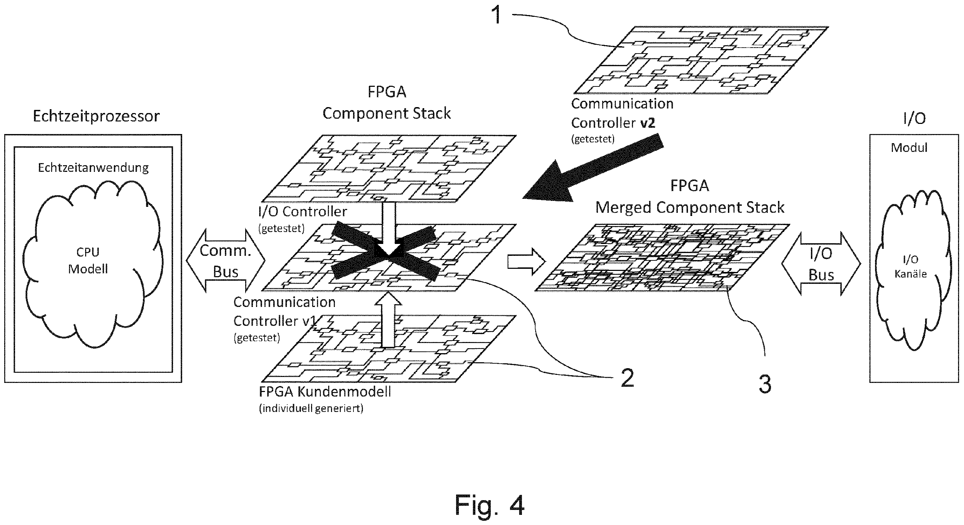

Der Austausch einer Komponente der Kunden FPGA Konfiguration gegen eine getestete neue Version mit festem Placement ist in Fig. 4 dargestellt. Die Kundenlogik wird um die abgesicherten bestehenden Schaltungskomponenten 2 neuplatziert, wodurch die Funktionalität der weiteren Schaltungskomponente 1 gewährleistet ist. Auf dieselbe Weise kann auch eine neuere Version ("Communication Controller v2") einer Standard I/O Kanalfunktionalität ("Communication Controller v1") in einem FPGA mit veränderlicher Logik, wie beispielsweise bei Flexible I/O ausgetauscht werden, wobei der Austausch sowohl mit der additiven als auch der subtraktiven Methode erfolgen kann.

Die beschriebenen Ausführungsbeispiels sind lediglich Beispiele, die im Rahmen der Ansprüche auf vielfältige Weise modifiziert und/oder ergänzt werden können. Jedes Merkmal, das für ein bestimmtes Ausführungsbeispiel beschrieben wurde, kann eigenständig oder in Kombination mit anderen Merkmalen in einem beliebigen anderen Ausführungsbeispiel genutzt werden. Jedes Merkmal, dass für ein Ausführungsbeispiel einer bestimmten Kategorie beschrieben wurde, kann auch in entsprechender Weise in einem Ausführungsbeispiel einer anderen Kategorie eingesetzt werden.

B ezugszei chenli ste

| | |
|---|---|
| Weitere Schaltungskomponente | 1 |
| Bestehende Schaltungskomponente | 2 |
| FPGA Konfiguration | 3 |

**Patentansprüche**

1. Verfahren zum Hinzufügen einer weiteren Schaltungskomponente (1) mit auf einem FPGA ausführbaren Operationen zu einer FPGA Konfiguration (3), wobei
die FPGA Konfiguration (3) bereits wenigstens eine in der FPGA Konfiguration (3) örtlich verteilt angeordnete bestehende Schaltungskomponente (2) mit auf dem FPGA ausführbaren Operationen aufweist, mit den Schritten:

Synthetisieren der weiteren Schaltungskomponente (1) zum Erhalten einer weiteren Netzliste, und verteiltes Anordnen der weiteren Netzliste unter Berücksichtigung der wenigstens einen bestehenden Schaltungskomponente (2) in der FPGA Konfiguration (3).

2. Verfahren nach dem vorhergehenden Anspruch, wobei das Anordnen den Schritt umfasst:
Inkrementelles Hinzufügen der weiteren Netzliste bei gesperrter wenigstens einer bestehenden Schaltungskomponente (2).

3. Verfahren nach einem der vorhergehenden Ansprüche, mit dem Schritt nach dem Anordnen:
Entfernen der wenigstens einen bestehenden Schaltungskomponente (2).

4. Verfahren nach dem vorhergehenden Anspruch, wobei das Entfernen die Schritte umfasst:

Sperren der weiteren Schaltungskomponente (1), und
sequentielles Entfernen wenigstens einer bestehenden Netzliste der wenigstens einen bestehenden Schaltungskomponente (2).

5. Verfahren nach dem vorhergehenden Anspruch 1, mit den Schritten:

Sperren der weiteren Schaltungskomponente (1), und
Exportieren der Anordnung der weiteren Schaltungskomponente (1) zur Berücksichtigung beim Hinzufügen einer noch weiteren Schaltungskomponente (1).

6. Verfahren nach einem der vorhergehenden Ansprüche, mit dem Schritt:

Einlesen der wenigstens einen bestehenden Schaltungskomponente (2) einschließlich der wenigstens einen bestehenden Netzliste, und/oder
Entfernen nicht verwendeter Schaltungskomponenten aus der Anordnung der weiteren Schaltungskomponente (1) zusammen mit der wenigstens einen bestehenden Schaltungskomponente (2).

7. Verfahren nach einem der vorhergehenden Ansprüche, wobei das Anordnen der weiteren Schaltungskomponente (1) unter Beibehaltung einer Anordnung der wenigstens einen bestehenden Schaltungskomponente (2) erfolgt.

8. Verfahren nach einem der vorhergehenden Ansprüche, wobei das Anordnen in durch die wenigstens eine bestehende Schaltungskomponente (2) unbelegten Freiräumen der FPGA Konfiguration (3) erfolgt.

9. Verfahren nach einem der vorhergehenden Ansprüche, wobei durch das Anordnen die wenigstens eine bestehende Schaltungskomponente (2) und die weitere Schaltungskomponente (1) in gleichen Partitionen der FPGA Konfiguration (3) platziert sind und/oder die wenigstens eine bestehende Schaltungskomponente (2) und die weitere Schaltungskomponente (1) partitionsfrei in der FPGA Konfiguration (3) angeordnet sind.

10. Verfahren nach einem der vorhergehenden Ansprüche, mit dem Schritt:
Einzelnes Testen der wenigstens einen bestehenden Schaltungskomponente (2) und der weiteren Schaltungskomponente (1).

11. Verfahren nach einem der vorhergehenden Ansprüche, aufweisend eine Mehrzahl bestehender unter jeweiliger Berücksichtigung anderer bestehender Schaltungskomponenten verteilt angeordneter Schaltungskomponenten auf der FPGA Konfiguration (3) und/oder umfassend den Schritt:
Anordnen einer Mehrzahl weiterer Schaltungskomponenten.

12. Verfahren nach einem der vorhergehenden Ansprüche, aufweisend eine Mehrzahl bestehender unter jeweiliger Berücksichtigung anderer bestehender Schaltungskomponenten verteilt angeordneter Schaltungskomponenten auf der FPGA Konfiguration (3) und umfassend den Schritt:
sequentielles Entfernen mindestens einer bestehenden Schaltungskomponente (2) aus der FPGA Konfiguration (3) und Ersetzen der entfernten Schaltungskomponente durch eine andere Version der Schaltungskomponente, die unter Berücksichtigung aller anderen bestehenden Schaltungskomponenten (2) erstellt wurde.

13. Verfahren nach dem vorhergehenden Anspruch, wobei die FPGA Konfiguration (3) wenigstens eine verteilt angeordnete weitere Schaltungskomponente (1) aufweist, die sequentiell entfernt wird und deren andere Version in Freiräume insbesondere der entfernten Schaltungskomponente (1) oder über alle vorhandenen Freiräume angeordnet wird.

14. Nichtflüchtiges, computerlesbares Speichermedium mit darauf abgespeicherten Befehlen, die bei ihrer Ausführung auf einem Prozessor ein Verfahren nach einem der vorhergehenden Ansprüche bewirken.

Schaltungskomponente 5

Schaltungskomponente 4

Schaltungskomponente 3

Schaltungskomponente 2

Schaltungskomponente 1

Fig. 1

Schaltungskomponente 5

Schaltungskomponente 4

Schaltungskomponente 3

Schaltungskomponente 2

Schaltungskomponente 1

2

„Merged Component Stack"

1

3

Fig. 2

EP 4 148 613 A1

Fig. 3

I/O Modul

I/O Kanäle

Communication Controller **v2** (getestet)

FPGA Merged Component Stack

I/O Bus

FPGA Component Stack

I/O Controller (getestet)

Communication Controller v1 (getestet)

FPGA Kundenmodell (individuell generiert)

Comm. Bus

Echtzeitprozessor

Echtzeitanwendung

CPU Modell

1

2

3

Fig. 4

Europäisches
Patentamt

European
Patent Office

Office européen
des brevets

# EUROPÄISCHER RECHERCHENBERICHT

Nummer der Anmeldung

EP 22 19 4640

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2020/134108 A1 (POSSIGNOLO RAFAEL [US] ET AL) 30. April 2020 (2020-04-30) <br> * Zusammenfassung * <br> * Seite 1 - Seite 33; Abbildungen 1,6,7,10 * <br> ----- | 1-14 | INV. <br> G06F30/34 <br> G06F30/18 <br> G06F30/33 <br> G06F30/343 <br> G06F30/347 |
| X | POSSIGNOLO RAFAEL TRAPANI RPOSSIGN@UCSC EDU ET AL: "SMatch Structural Matching for Fast Resynthesis in FPGAs", DESIGNING INTERACTIVE SYSTEMS CONFERENCE, ACM, 2 PENN PLAZA, SUITE 701NEW YORKNY10121-0701USA, 2. Juni 2019 (2019-06-02), Seiten 1-6, XP058637289, DOI: 10.1145/3316781.3317912 ISBN: 978-1-4503-5850-7 <br> * Zusammenfassung * <br> * Seite 1 - Seite 6; Abbildung 4 * <br> ----- | 1-14 | G06F30/327 |
| A | US 2021/256190 A1 (KALTE HEIKO [DE] ET AL) 19. August 2021 (2021-08-19) <br> * Zusammenfassung * <br> * Seite 1 - Seite 14; Abbildungen 1,3,9 * <br> ----- | 1-14 | |

RECHERCHIERTE SACHGEBIETE (IPC)

G06F

Der vorliegende Recherchenbericht wurde für alle Patentansprüche erstellt

| Recherchenort | Abschlußdatum der Recherche | Prüfer |
|---|---|---|
| München | 17. Januar 2023 | Brandiska, Pavlina |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 19 4640

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-01-2023

| Im Recherchenbericht angeführtes Patentdokument | Datum der Veröffentlichung | Mitglied(er) der Patentfamilie | | Datum der Veröffentlichung |
|---|---|---|---|---|
| US 2020134108 A1 | 30-04-2020 | US | 2020134108 A1 | 30-04-2020 |
| | | US | 2021110092 A1 | 15-04-2021 |
| US 2021256190 A1 | 19-08-2021 | CN | 113343623 A | 03-09-2021 |
| | | EP | 3869380 A1 | 25-08-2021 |
| | | US | 2021256190 A1 | 19-08-2021 |

EPO FORM P0461

Für nähere Einzelheiten zu diesem Anhang : siehe Amtsblatt des Europäischen Patentamts, Nr.12/82